# EUROPÄISCHE PATENTANMELDUNG

(11) **EP 1 643 554 A2**
(43) Veröffentlichungstag der Anmeldung: **05.04.2006**
(21) Anmeldenummer: 05021499.8
(22) Anmeldetag: 30.09.2005
(51) Int. Cl.: H01L 25/075, H01L 33/00

(54) **Leuchtdiodenanordnung**

(30) Priorität: 30.09.2004 DE 102004047763
(71) Anmelder: Osram Opto Semiconductors GmbH, 93049 Regensburg (DE)
(72) Erfinder: Streubel, Klaus, 93164 Laaber (DE)
(74) Vertreter: Epping - Hermann - Fischer

(57) **Zusammenfassung**

Die vorliegende Erfindung beschreibt ein strahlungsemittierendes Halbleiterbauelement mit einer Mehrzahl von Halbleiterkörpern (10, 20, 30), die jeweils eine aktive Zone (11, 21, 31) aufweisen und im Betrieb Licht mit jeweils einer unterschiedlichen Zentralwellenlänge (λ₁₀, λ₂₀, λ₃₀) und einer zugeordneten spektralen Bandbreite (Δλ₁₀, Δλ₂₀, Δλ₃₀) emittieren, so dass durch die Mischung dieses Lichts der Eindruck weißen Lichts steht. Bei mindestens einem der Halbleiterkörper (10) variiert die Emissionswellenlänge in der aktiven Zone (11) in einer vorgegebenen Weise, so dass dadurch die spektrale Bandbreite (Δλ₁₀) des emittierenden Lichts erhöht ist.

## Beschreibung

Die vorliegende Erfindung bezieht sich auf eine Mehrfachleuchtdiodenanordnung nach dem Oberbegriff des Patentanspruchs 1.

Diese Patentanmeldung beansprucht die Priorität der deutschen Patentanmeldung DE 10 2004 047 763.9-33, deren Offenbarungsgehalt hiermit durch Rückbezug aufgenommen wird.

Bei bekannten derartigen Mehrfachleuchtdiodenanordnungen ist eine Mehrzahl von Halbleiterkörpern in einem gemeinsamen Gehäuse angeordnet. Die Halbleiterkörper emittieren im Betrieb Licht unterschiedlicher Wellenlänge, beispielsweise im roten, grünen und blauen Spektralbereich, so dass insgesamt ein solches Bauelement mischfarbiges oder weißes Licht abstrahlt. Der Farbort des erzeugten Lichts kann durch eine geeignete Ansteuerung der einzelnen Halbleiterkörper variiert werden. Zur Erzeugung von weißem Licht ist dazu ein Farbort zu wählen, der innerhalb des Weißbereichs liegt. Der Weißbereich umgibt im CIE-Farbraum den sogenannten Weißpunkt mit dem Farbort x = y = 0,33.

Herkömmliche Weißlichtquellen wie beispielsweise Glühlampen oder Entladungslampen werden unter anderem durch die Farbtemperatur und den Farbwiedergabeindex als lichttechnische Größen charakterisiert.

Die Farbtemperatur ist die Temperatur eines schwarzen Strahlers, dessen Farbort dem Farbort der zu charakterisierenden Weißlichtquelle am nächsten kommt (ähnlichste Farbtemperatur oder Correlated Color Temperature, CCT).

Der Farbwiedergabeindex gibt an, wie groß die mittlere Farbabweichung von festgelegten Testfarbfeldern bei Beleuchtung mit der zu charakterisierenden Lichtquelle im Vergleich zur Beleuchtung mit einer definierten Standardlichtquelle ist. Der maximale Farbwiedergabeindex beträgt 100 und entspricht einer Lichtquelle, bei der keine Farbabweichungen auftreten. Weitere Angabe zur Messung und Festlegung des Farbwiedergabeindex sind in der DIN 6169 angegeben.

Die Farbtemperatur ist somit ein auf den schwarzen Strahler bezogenes Maß für den Farbort einer Weißlichtquelle, während der Farbwiedergabeindex die Qualität der Lichtquelle im Hinblick auf einen möglichst unverfälschten Farbeindruck eines Objekts bei Beleuchtung mit dieser Lichtquelle angibt.

Bei den eingangs genannten bekannten Mehrfachleuchtdiodenanordnungen ist die Farbtemperatur in gewissen Grenzen durch eine entsprechende Einstellung des Farbortes mittels einer geeigneten Ansteuerung der einzelnen Halbleiterkörper einstellbar. Der Farbwiedergabeindex hingegen ist in der Regel durch die Strukturen und das Material der Halbleiterkörper fest vorgegeben. Typischerweise liegt dieser Farbwiedergabeindexbereich im Bereich von 45 bis 55. Im Vergleich dazu weisen herkömmliche Glühlampen einen Farbwiedergabeindex 98 und mehr auf.

Es ist Aufgabe der vorliegenden Erfindung, eine Mehrfachleuchtdiodenanordnung der eingangs genannten Art mit einem verbesserten Farbwiedergabeindex zu schaffen.

Diese Aufgabe wird durch eine Mehrfachleuchtdiodenanordnung mit den Merkmalen des Patentanspruchs 1 gelöst. Vorteilhafte Weiterbildungen der Erfindung sind Gegenstand der abhängigen Ansprüche.

Erfindungsgemäß ist ein strahlungsemittierendes Halbleiterbauelement mit einer Mehrzahl von Halbleiterkörpern vorgesehen, die jeweils eine aktive Zone aufweisen und im Betrieb Licht mit jeweils unterschiedlicher Zentralwellenlänge und einer dieser Zentralwellenlänge zugeordneten spektralen Bereiche emittieren, wobei bei mindestens einem der Halbleiterkörper die Emissionswellenlänge der aktiven Zone in einer vorgegebenen Weise variiert, und dadurch die spektrale Bandbreite des emittierten Lichts erhöht ist. Bevorzugt entsteht durch die Mischung des von den Halbleiterkörper emittierten Lichts der Eindruck weißen Lichts. Die Zentralwellenlänge wird auch als Peakwellenlänge bezeichnet. Unter der spektralen Bandbreite ist im Zweifel die spektrale Halbwertsbreite (FWHM, Full Width Half Maximum) zu verstehen.

Die Erfindung geht dabei von dem Gedanken aus, dass bei den eingangs genannten Mehrfachleuchtdiodenanordnungen die einzelnen Halbleiterkörper Licht mit einer vergleichsweise geringen spektralen Bandbreite emittieren und somit das gesamte Emissionsspektrum des Bauelements eine Mehrzahl von einzelnen Spektrallinien aufweist. Im Gegensatz dazu zeigen Glühlampen ein breites kontinuierliches Spektrum. Um die Farbwiedergabe einer Mehrfachleuchtdiodenanordnung zu verbessern, ist daher im Rahmen der Erfindung vorgesehen, die spektrale Bandbreite des von den einzelnen Halbleiterkörpern emittierten Lichts zu erhöhen, um so das Emissionsspektrum der Mehrfachleuchtdiodenanordnungen an das Emissionsspektrum einer Glühlampe anzunähern. Es hat sich dabei im Rahmen der Erfindung überraschenderweise herausgestellt, dass bereits eine vergleichsweise geringe Erhöhung der spektralen Bandbreite bei nur einem der Halbleiterkörper zu einer deutlichen Erhöhung des Farbwiedergabeindex führen kann.

Vorzugsweise besteht bei einer Ausgestaltung der Erfindung die von dem Halbleiterbauelement insgesamt emittierte Strahlung aus dem von den Halbleiterkörpern emittierten Licht, so dass also kein weiterer, insbesondere eine spektrale Verbreiterung herbeiführende Emitter wie beispielsweise ein Leuchtstoff vorzusehen ist. In diesem Fall ist die Erhöhung der Bandbreite des von dem mindestens einen Halbleiterkörper emittierten Lichts vorteilhaft, da allein mit den Halbleiterkörpern eine Annäherung des Emissionsspektrums an das Emissionsspektrum einer Glühlampe bzw. eine Verbesserung des Farbwiedergabeindex erreicht wird.

Alternativ kann bei einer anderen Ausgestaltung der Erfindung vorgesehen sein, dass einem der Halbleiterkörper, mehreren oder auch allen Halbleiterkörpern ein Lumineszenzkonversionselement, etwa in Form eines Leuchtstoffs, der beispielsweise in Form von Leuchtstoffpartikeln in einem Matrixmaterial verteilt sein kann, in Abstrahlrichtung nachgeordnet ist. Dieses Lumineszenzkonversionselement wandelt das von dem Halbleiterkörper beziehungsweise den Halbleiterkörpern erzeugte Licht in Licht anderer Wellenlänge um. Hiermit kann gegebenenfalls eine weiter verbesserte Annäherung des Emissionsspektrums an das Emissionsspektrum einer Glühlampe bzw. eine weitergehende Verbesserung des Farbwiedergabeindex erzielt werden.

Bei einer vorteilhaften Weiterbildung der Erfindung ist die aktive Zone des mindestens einen Halbleiterkörpers derart ausgeführt, dass die Emissionswellenlänge innerhalb dieser aktiven Zone in vertikaler Richtung zunimmt oder abnimmt.

Bei einer ersten bevorzugten Variante der Erfindung wird dies dadurch erreicht, dass die aktive Zone eine Mehrfachquantentopfstruktur umfasst, deren Quantentöpfe verschiedene Quantisierungsenergien aufweisen. Die einzelnen Quantentöpfe emittieren somit Licht mit einer leicht verschiedenen Zentralwellenlänge, so dass die Mehrfachquantenstruktur insgesamt Licht mit einer erhöhte spektralen Bandbreite erzeugt.

Die Bezeichnung Quantentopfstruktur umfasst im Rahmen der vorliegenden Erfindung alle Strukturen, bei denen Ladungsträger durch Einschluss ("Confinement") eine Quantisierung ihrer Energiezustände erfahren. Insbesondere beinhaltet die Bezeichnung Quantentopfstruktur keine Angabe über die Dimensionalität der Quantisierung. Sie umfasst somit unter anderem Quantentröge, Quantendrähte und Quantenpunkte sowie alle Kombinationen dieser Strukturen.

Bei einer zweiten Variante der Erfindung enthält die aktive Zone ein Halbleitermaterial, dessen Zusammensetzung sich innerhalb der aktiven Zone in vertikaler Richtung in einer vorgegebenen Weise ändert. Dieser sogenannte Kompositionsgradient ist so ausgeführt, dass in vertikaler Richtung der Bandabstand des Halbleitermaterials zunimmt oder abnimmt und sich somit in entsprechender Weise die Emissionswellenlänge in vertikaler Richtung derart ändert, dass insgesamt die spektrale Bandbreite des emittierten Lichts erhöht ist. Als Halbleitermaterial für diese Variante eignet sich insbesondere InGaAlP, da bei diesem quaternären Halbleitermaterialsystem die Wellenlänge unabhängig von der Gitterkonstante in vorgegebenen Grenzen einstellbar ist und somit ein Kompositionsgradient ohne Gitterfehlanpassung ausgebildet werden kann.

Bei einer dritten Variante der Erfindung kann die aktive Zone auch eine Mehrzahl von aktiven Schichten unterschiedlicher Emissionswellenlänge, die zum Beispiel jeweils eine entsprechende Quantentopfstruktur, umfassen. Zweckmäßigerweise ist der Unterschied der Emissionswellenlängen dabei so gering, dass das Spektrum des von dem Halbleiterkörper insgesamt im wesentlichen eine einzige, verbreiterte Emissionslinie und insbesondere keine Mehrzahl lokaler Maxima aufweist.

Es sei angemerkt, dass die genannten Varianten auch kombinierbar sind, beispielsweise in Form einer Mehrfachquantentopfstruktur, bei der sich in vertikaler Richtung die Zusammensetzung des Halbleitermaterials und/oder die Dimensionierung der Quantentöpfe ändert.

Vorzugsweise weist bei der Erfindung der mindestens eine Halbleiterkörper eine der aktiven Zone in vertikaler Richtung nachgeordnete Auskoppelfläche auf, wobei die Emissionswellenlänge innerhalb der aktiven Zone in Richtung der Auskoppelfläche abnimmt. Hierdurch wird erreicht, dass die kurzwelligere Strahlung auf der der Auskoppelfläche zugewandten Seite erzeugt und somit die Reabsorption der erzeugten Strahlung innerhalb der aktiven Zone verringert wird.

Bei einer ersten bevorzugten Ausführungsform der Erfindung umfasst die Mehrzahl der Halbleiterkörper einen ersten, im roten Spektralbereich emittierenden Halbleiterkörper, einen zweiten, im grünen Spektralbereich emittierenden Halbleiterkörper und einen dritten, im blauen Spektralbereich emittierenden Halbleiterkörper, wobei durch die Mischung des von dem ersten, dem zweiten und dem dritten Halbleiterkörper emittierten Lichts der Eindruck weißen Lichts entsteht.

Alternativ kann bei einer zweiten bevorzugten Ausführungsform der Erfindung die Mehrzahl der Halbleiterkörper einen ersten, im gelben oder orangen Spektralbereich emittierten Halbleiterkörper und einen zweiten, im blauen oder blaugrünen Spektralbereich emittierenden Halbleiterkörper umfassen, wobei durch die Mischung des von dem ersten und zweiten Halbleiterkörper emittierten Lichts der Eindruck weißen Lichts entsteht.

Die erste Ausführungsform weist hierbei den Vorteil auf, dass der Farbort beziehungsweise die Farbtemperatur durch geeignete Ansteuerung der genannten Halbleiterkörper in vergleichsweise großen Grenzen frei einstellbar ist. Bei der zweiten Ausführungsform ist demgegenüber die Anzahl der Halbleiterkörper vorteilhaft verringert.

Vorzugsweise ist bei der Erfindung die spektrale Bandbreite durch Variation der Emissionswellenlänge innerhalb der aktiven Zone bei demjenigen Halbleiterkörper erhöht, der die größte Zentralwellenlänge aufweist. Es hat sich herausgestellt, dass bereits eine Vergrößerung der spektralen Bandbreite nur bei diesem Halbleiterkörper zu einer wesentlichen Erhöhung des Farbwiedergabeindex führen kann. In der Regel emittiert dieser Halbleiterkörper im gelben, gelborangen oder roten Spektralbereich, so dass für die aktive Zone ein Material aus dem oben genannten vorteilhaften Materialsystem InGaAlP verwendet werden kann.

Weiter bevorzugt ist bei einer erfindungsgemäßen Mehrfachleuchtdiodenanordnung die erhöhte spektrale Bandbreite größer oder gleich 30 nm, besonders bevorzugt größer oder gleich 40 nm. Allgemein ist die Erhöhung der spektralen Bandbreite bei der Erfindung derart bemessen, dass der Farbwiedergabeindex des von dem Bauelement emittierten Lichts größer oder gleich 60, vorzugsweise größer oder gleich 80, besonders bevorzugt größer oder gleich 90 ist.

Weitere Merkmale, Vorzüge und Zweckmäßigkeiten der Erfindung ergeben sich aus der nachfolgenden Beschreibung eines Ausführungsbeispiels der Erfindung anhand der Figuren 1 bis 4.

Es zeigen:
- Figur 1.: eine schematische Detailschnittansicht des Ausführungsbeispiels einer erfindungsgemäßen Mehrfachleuchtdiodenanordnung,
- Figur 2: eine graphische Darstellung der spektralen Zusammensetzung des von dem Ausführungsbeispiel emittierten Lichts,
- Figur 3: eine graphische Darstellung der elektronischen Bandstruktur einer aktiven Zone bei dem Ausführungsbeispiel einer erfindungsgemäßen Mehrfachleuchtdiodenanordnung, und
- Figur 4A und 4B: eine schematische Aufsicht und eine schematische Seitenansicht des Ausführungsbeispiels einer erfindungsgemäßen Mehrfachleuchtdiodenanordnung.

Gleiche oder gleichwirkende Elemente sind in den Figuren mit denselben Bezugszeichen versehen.

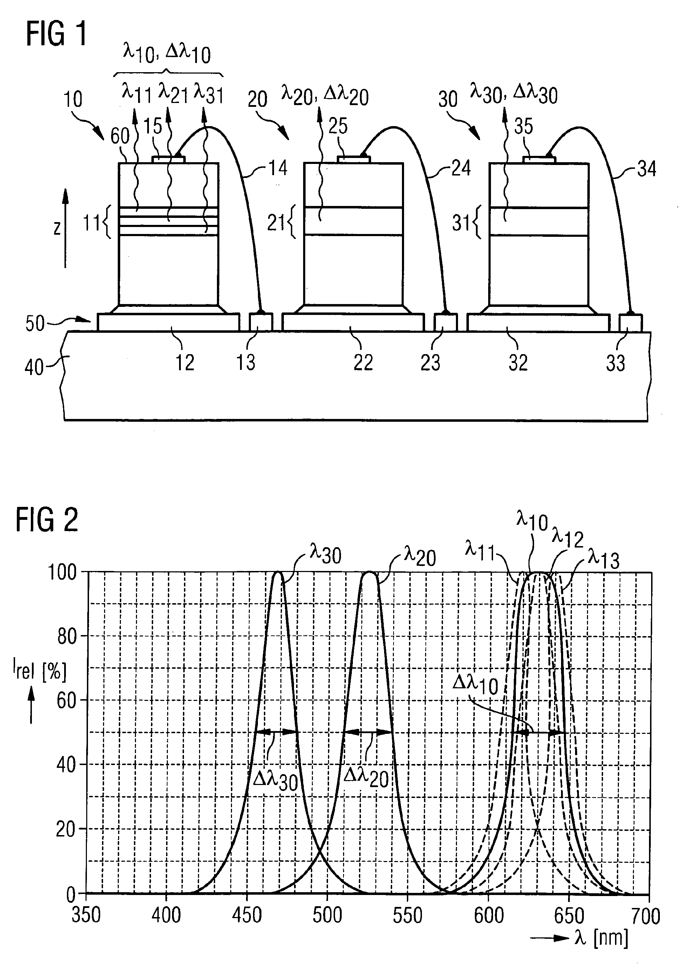

Das in Figur 1 dargestellte Ausführungsbeispiel weist einen ersten Halbleiterkörper 10, einen zweiten Halbleiterkörper 20 und einen dritten Halbleiterkörper 30 auf. Die Halbleiterkörper 10, 20, 30 sind jeweils auf einem Chipmontagebereich 12, 22, 32 eines Leiterrahmens 50 montiert. Der Leiterrahmen 50 ist mit einem Gehäusegrundkörper 40, der in Figur 1 nur ausschnittsweise dargestellt ist, befestigt.

Auf der von dem Leiterrahmen 50 abgewandten Seite sind die Halbleiterkörper 10, 20, 30 jeweils mit einer Kontaktmetallisierung 15, 25, 35 versehen. Von dieser Kontaktmetallisierung ist jeweils eine Drahtverbindung 14, 24, 34 zu einem Drahtanschluss 13, 23, 33 des Leiterrahmens 50 geführt.

Der Halbleiterkörper 10 emittiert im Betrieb Licht mit einer Zentralwellenlänge λ₁₀ und einer spektralen Bandbreite Δλ₁₀, der Halbleiterkörper 20 Licht mit einer Zentralwellenlänge λ₂₀ und einer spektralen Bandbreite Δλ₂₀ und der Halbleiterkörper 30 Licht mit einer Zentralwellenlänge λ₃₀ und einer spektralen Bandbreite Δλ₃₀. Die Zentralwellenlänge λ₁₀ kann beispielsweise im roten Spektralbereich, etwa bei 620 nm, die Zentralwellenlänge λ₂₀ im grünen Spektralbereich, etwa bei 530 nm und die Zentralwellenlänge λ₃₀ im blauen Spektralbereich, etwa bei 470 nm liegen.

Bei einer zweiten Ausführungsform der Erfindung können statt der in Figur 1 beispielhaft dargestellten drei Halbleiterkörper zwei Halbleiterkörper, wovon einer im blauen Spektralbereich, etwa bei 470 nm, und einer im orangen Spektralbereich, etwa bei 590 nm, emittieren kann, vorgesehen sein.

In Figur 2 sind für das in Figur 1 dargestellte Ausführungsbeispiel schematisch die Emissionsspektren der drei Halbleiterkörper 10, 20, 30 dargestellt. Aufgetragen ist die relative Intensität des emittierten Lichts in Abhängigkeit von der Wellenlänge.

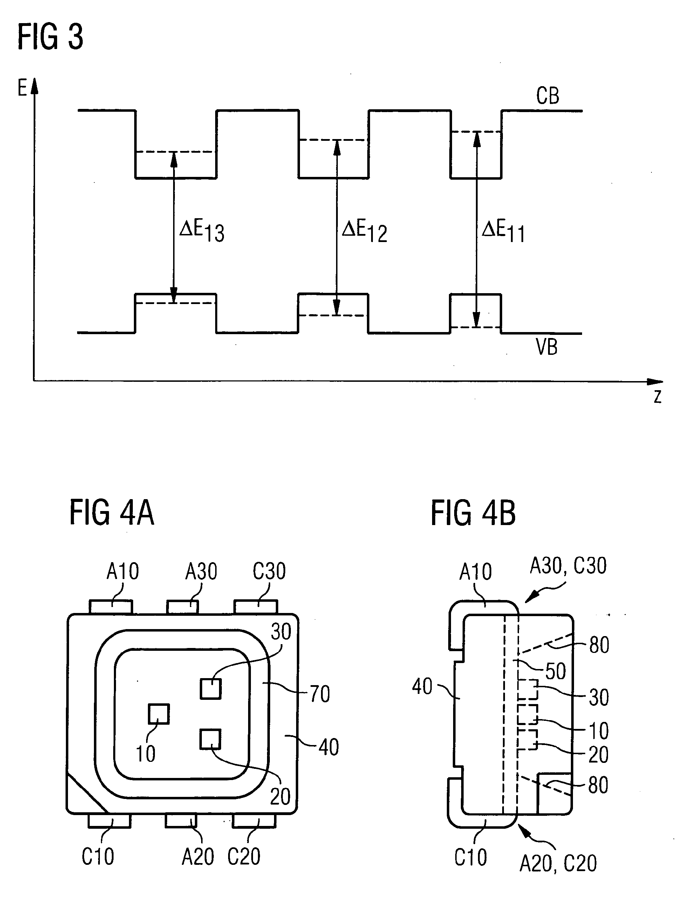

Im Unterschied zu den Spektren des von den Halbleiterkörpern 20 und 30 emittierte Lichts mit der Zentralwellenlänge λ₂₀ und der spektralen Bandbreite Δλ₂₀ beziehungsweise λ₃₀ und der spektralen Bandbreite Δλ₃₀ setzt sich das Spektrum des von dem Halbleiterkörpers 10 emittierten Lichts mit der Zentralwellenlänge λ₁₀ und der spektralen Bandbreite Δλ₁₀ aus einer Mehrzahl von spektralen Linien unterschiedlicher Zentralwellenlänge λ₁₁, λ₁₂ und λ₁₃ zusammen. Diese spektralen Linien entstehen dadurch, dass die Emissionswellenlänge in der aktiven Zone 11 des Halbleiterkörpers 10 in vertikaler z-Richtung (angedeutet durch den z-Pfeil in Figur 1) variiert. Dies wird im folgenden anhand von Figur 3 noch genauer erläutert.

Insgesamt weist das von dem Halbleiterkörper 10 emittierte Licht ein Spektrum auf, das durch die Summe der einzelnen Spektrallinien mit den Emissionswellenlängen λ₁₁, λ₁₂ und λ₁₃ gebildet wird. Die Erhöhung der spektralen Bandbreite Δλ₁₀ bemisst sich dabei an der Größe der Variation der Emissionswellenlänge innerhalb der aktiven Zone 11.

Bei dem gezeigten Ausführungsbeispiel beträgt die spektrale Bandbreite Δλ₁₀ etwa 20 nm, die spektrale Bandbreite Δλ₂₀ etwa 35 nm und die spektrale Bandbreite Δλ₃₀ etwa 20 nm. Hieraus ergibt sich bei geeigneter Ansteuerung der Mehrfachleuchtdiodenanordnung eine Weißlichtquelle mit einem Farbwiedergabeindex von 63. Herkömmlicherweise ist insbesondere die Linienbreite des längstwellig emittierten Halbleiterkörpers 10 geringer und beträgt etwa 15 nm, wodurch sich ein deutlich kleinerer Farbwiedergabeindex von etwa 50 ergibt.

Die spektralen Bandbreiten Δλ₁₀, Δλ₂₀ und Δλ₃₀ sowie der Farbwiedergabeindex (CRI, Color Rendering Index) sind in der folgenden Tabelle für drei Variationen A, B und C des Ausführungsbeispiels mit jeweils unterschiedlicher spektraler Bandbreite des längstwellig emittierenden Halbleiterkörpers zusammengefasst. Zum Vergleich sind die entsprechenden Daten einer herkömmlichen Mehrfachleuchtdiodenanordnung ebenfalls angegeben. Die zugehörigen Zentralwellenlängen λ₁₀, λ₂₀ und λ₃₀ betragen wie bereits angegeben 620 nm, 530 nm beziehungsweise 470 nm.

| Variation | Δλ₁₀ (nm) | Δλ₂₀ (nm) | Δλ₂₀ (nm) | CRI |
|---|---|---|---|---|
| A | 20 | 35 | 20 | 63 |
| B | 30 | 35 | 20 | 80 |
| C | 40 | 35 | 20 | 90 |
| Stand der Technik | 15 | 35 | 20 | 50 |

Überraschenderweise hat sich im Rahmen der Erfindung gezeigt, dass bereits mit der Erhöhung der spektralen Bandbreite des längstwellig emittierenden Halbleiterkörpers eine deutliche Erhöhung des Farbwiedergabeindex erzielt werden kann.

Für die zweite Ausführungsform der Erfindung mit zwei Halbleiterkörpern sind in der nachfolgenden Tabelle entsprechend die spektrale Bandbreiten und der Farbwiedergabeindex für drei Variationen A, B und C mit unterschiedlicher spektraler Bandbreiten des längstwellig emittierenden Halbleiterkörpers sowie zum Vergleich die entsprechenden Daten einer Mehrfachleuchtdiodenanordnung nach dem Stand der Technik angegeben. Die zugehörigen Zentralwellenlängen λ₁₀ und λ₂₀ hier betragen wie bereits angegeben 590 nm beziehungsweise 470 nm.

| Variation | Δλ₁₀ (nm) | Δλ₂₀ (nm) | CRI |
|---|---|---|---|
| A | 20 | 20 | 56 |
| B | 30 | 20 | 64 |
| C | 40 | 20 | 65 |
| Stand der Technik | 15 | 20 | 47 |

Wiederum kann bereits mit einer Erhöhung der spektralen Bandbreite bei dem längstwellig emittierenden Halbleiterkörper eine deutliche Erhöhung des Farbwiedergabeindex erzielt werden.

In Figur 3 ist eine beispielhafte Bandstruktur des Halbleiterkörpers 10 schematisch dargestellt.

Die aktive Zone 11 des Halbleiterkörpers 10 ist hierbei als Mehrfachquantentopfstruktur ausgebildet. Aufgetragen sind in Figur 3 für das Leitungsband CB und das Valenzband VB der Verlauf des jeweiligen Energieniveaus in z-Richtung.

Die Bandstruktur weist eine Mehrzahl von Quantentöpfen auf, wobei die Breite der Quantentöpfe mit steigender z-Richtung abnimmt. Aufgrund der Abhängigkeit der Quantisierungsenergie von der Ausdehnung des Quantentopfs wird dadurch erreicht, dass mit steigender z-Richtung die Quantisierungsenergie der einzelnen Quantentöpfe zunimmt. In der Folge emittiert der links dargestellte Quantentopf mit der Quantisierungsenergie ΔE₁₃ längerwellige Strahlung als die in steigender z-Richtung nachgeordneten Quantentöpfe mit den Quantisierungsenergien ΔE₁₂ beziehungsweise ΔE₁₁.

Eine ähnliche Variation der Emissionswellenlänge des emittierten Lichts der aktiven Zone kann bei der Erfindung auch dadurch erreicht werden, dass die Zusammensetzung des Halbleitermaterials in der aktiven Zone in einer vorgegebenen Weise derart variiert, dass sich der Bandabstand innerhalb der aktiven Zone - vorzugsweise in vertikaler Richtung - ändert. Es sei angemerkt, dass eine solche, auch als Kompositionsgradient bezeichnete Variation, auch mit der oben genannten Quantentopfstruktur kombiniert werden kann, so dass also beispielsweise eine Quantentopfstruktur ausgebildet ist, bei der die Dimensionierung und/oder die Zusammensetzung des Halbleitermaterials innerhalb der aktiven Zone variiert.

Vorzugsweise ist, wie in Figur 1 in Verbindung mit Figur 3 dargestellt, die Variation der Emissionswellenlänge λ₁₁, λ₁₂ und λ₁₃ so ausgeführt, dass die Emissionswellenlänge in Richtung der Auskoppelfläche 60 abnimmt. Wie insbesondere aus Figur 3 deutlich wird, wird hierdurch die Reabsorption des emittierten Lichts innerhalb der aktiven Zone vorteilhaft reduziert. So wird beispielsweise Licht, das von dem Quantentopf mit der niedrigsten Quantisierungsenergie ΔE₁₃ emittiert wird, von dem in wachsender z-Richtung und damit also in Richtung der Auskoppelfläche nachgeordneten Quantentöpfen nicht oder nur in geringem Umfang absorbiert wird, da deren Quantisierungsenergie ΔE₁₁ beziehungsweise ΔE₁₃ größer als die Energie dieses Lichts ist.

In Figur 4A ist eine Aufsicht auf das Ausführungsbeispiel einer erfindungsgemäßen Mehrfachleuchtdiodenanordnung dargestellt, Figur 4B zeigt die zugehörige Seitenansicht.

Die Halbleiterkörper 10, 20 und 30 sind in einer Ausnehmung 70 eines gemeinsamen Gehäusegrundkörpers 40 angeordnet. Die Seitenwände 80 der Ausnehmung 70 sind nach Art eines Reflektors schräg angeordnet und erhöhen so die Lichtausbeute des Bauelements.

Die den Halbleiterkörpern 10, 20 und 30 zugeordneten Chip-und Drahtanschlussbereiche (nicht dargestellt) sind als Anschlüsse A10, C10, A20, C20, A30 und C30 aus dem Gehäusegrundkörper 40 herausgeführt und erstrecken sich nach Art eines oberflächenmontierbaren Bauelements bis zur Montageseite.

Die Erfindung ist nicht durch die Beschreibung anhand der Ausführungsbeispiele beschränkt. Insbesondere können bei der Erfindung auch mehrere oder sogar alle Halbleiterkörper eine entsprechend erhöhte spektrale Bandbreite aufweisen. Die Erfindung umfasst weiterhin auch alle Kombinationen der in den Ausführungsbeispielen und der sonstigen Beschreibung genannten Merkmale, insbesondere alle Kombinationen der in den Patentansprüchen genannten Merkmale, selbst wenn diese Kombinationen nicht explizit in den Patentansprüchen oder Ausführungsbeispielen angegeben sind.

## Patentansprüche

1. Strahlungsemittierendes Halbleiterbauelement mit einer Mehrzahl von Halbleiterkörpern (10, 20, 30), die jeweils eine aktive Zone (11, 12, 13) aufweisen und im Betrieb Licht mit jeweils einer unterschiedlichen Zentralwellenlänge (λ₁₀, λ₂₀, λ₃₀) und einer zugeordneten spektralen Bandbreite (Δλ₁₀, ^{Δλ}20, ^{Δλ}30⁾ emittieren,
**dadurch gekennzeichnet, dass**
bei mindestens einem der Halbleiterkörper (10) die Emissionswellenlänge (λ₁₀) in der aktiven Zone (11) in einer vorgegebenen Weise variiert, und **dadurch** die spektrale Bandbreite (Δλ₁₀) des von diesem Halbleiterkörper (10) emittierten Lichts erhöht ist.

2. Strahlungsemittierendes Halbleiterbauelement nach Anspruch 1,
**dadurch gekennzeichnet, dass**
innerhalb der aktiven Zone (11) des mindestens einen Halbleiterkörpers (10) die Emissionswellenlänge (λ₁₀) in vertikaler Richtung-zunimmt oder abnimmt.

3. Strahlungsemittierendes Halbleiterbauelement nach Anspruch 1 oder 2,
**dadurch gekennzeichnet, dass**
die aktive Zone (11) des mindestens einen Halbleiterkörpers (10) eine Quantentopfstruktur mit einer Mehrzahl von Quantentöpfen unterschiedlicher Quantisierungsenergie aufweist.

4. Strahlungsemittierendes Halbleiterbauelement nach einem der Ansprüche 1 bis 3,
**dadurch gekennzeichnet, dass**
die aktive Zone (11) des mindestens einen Halbleiterkörpers (10) ein Halbleitermaterial enthält, dessen Zusammensetzung innerhalb der aktiven Zone in einer vorgegebenen Weise variiert.

5. Strahlungsemittierendes Halbleiterbauelement nach Anspruch 4,
**dadurch gekennzeichnet, dass**
die aktive Zone (11) InₓAl_{y}Ga_{1-x-y}P mit 0 ≤ x ≤ 1, 0 ≤ y ≤ 1 und 0 ≤ x + y ≤ 1 enthält.

6. Strahlungsemittierendes Halbleiterbauelement nach einem der Ansprüche 1 bis 5,
**dadurch gekennzeichnet, dass**
der mindestens eine Halbleiterkörpers (10) eine der aktiven Zone (11) in vertikaler Richtung nachgeordnete Auskoppelfläche (6) aufweist, und die Emissionswellenlänge (λ₁₀) innerhalb der aktiven Zone (11) in Richtung der Auskoppelfläche (6) abnimmt.

7. Strahlungsemittierendes Halbleiterbauelement nach einem der Ansprüche 1 bis 6,
**dadurch gekennzeichnet, dass**
die Mehrzahl der Halbleiterkörper einen ersten, im gelben oder orangen Spektralbereich emittierenden Halbleiterkörper und einen zweiten, im blauen oder blaugrünen Spektralbereich emittierenden Halbleiterkörper umfasst.

8. Strahlungsemittierendes Halbleiterbauelement nach einem der Ansprüche 1 bis 6,
**dadurch gekennzeichnet, dass**
die Mehrzahl der Halbleiterkörper einen ersten, im roten Spektralbereich emittierenden Halbleiterkörper, einen zweiten, im grünen Spektralbereich emittierenden Halbleiterkörper und einen dritten, im blauen Spektralbereich emittierenden Halbleiterkörper umfasst.

9. Strahlungsemittierendes Halbleiterbauelement nach einem
der Ansprüche 1 bis 8,
**dadurch gekennzeichnet, dass**
der Halbleiterkörper (10) mit der längsten Zentralwellenlänge (λ₁₀) eine spektrale Bandbreite (Δλ₁₀) aufweist, die durch Variation der Emissionswellenlänge in der aktiven Zone (11) erhöht ist.

10. Strahlungsemittierendes Halbleiterbauelement nach Anspruch 9,
**dadurch gekennzeichnet, dass**
nur bei dem Halbleiterkörper(10) mit der längsten Zentralwellenlänge (λ₁₀) die spektrale Bandbreite (Δλ₁₀) durch Variation der Emissionswellenlänge in der aktiven Zone (11) erhöht ist.

11. Strahlungsemittierendes Halbleiterbauelement nach einem der Ansprüche 1 bis 10,
**dadurch gekennzeichnet, dass**
die spektrale Bandbreite (Δλ₁₀) des mindestens einen Halbleiterkörpers (10) größer oder gleich 20 nm, bevorzugt größer oder gleich 30 nm, besonders bevorzugt größer oder gleich 40 nm ist.

12. Strahlungsemittierendes Halbleiterbauelement nach einem
der Ansprüche 1 bis 11,
**dadurch gekennzeichnet, dass**
die spektrale Bandbreite bei einem oder mehreren der Halbleiterkörper (10, 20, 30) derart erhöht ist, dass der Farbwiedergabeindex des von dem Bauelement emittierten Lichts größer oder gleich 60, vorzugsweise größer oder gleich 80, besonders bevorzugt größer oder gleich 90 ist.

13. Strahlungsemittierendes Halbleiterbauelement nach einem der Ansprüche 1 bis 12,
**dadurch gekennzeichnet, dass**
durch die Mischung des von den Halbleiterkörpern emittierten Lichts der Eindruck weißen Lichts entsteht.
